# EUROPEAN PATENT APPLICATION

(11) **EP 4 734 686 A1**
(43) Date of publication of application: **29.04.2026**
(21) Application number: 25207853.0
(22) Date of filing: 09.10.2025
(51) Int. Cl.: H05K 7/20

(54) **A FAN COVER AND A METHOD OF DIVERTING OUTPUT AIR USING FAN COVER**

(30) Priority: 24.10.2024 IN 202421081198
(71) Applicant: Vertiv Corporation, Westerville, OH 43082 (US)
(72) Inventor: BURADKAR, Nayush Sanjay, Westerville, 43082 (US); BHINTADE, Rahul, Westerville, 43082 (US); DANGE, Dhiraj, Westerville, 43082 (US)
(74) Representative: Bryn-Jacobsen, Caelia

(57) **Abstract**

The present disclosure provides a fan cover (210) for a fan (208) configured to divert the output air of the fan (208) in an electronic equipment (200) to prevent the generation of thermal blind spots (114). The fan cover (210) comprises a frame defined by a hollow body with a base (212) configured to securely fit on the rear surface of the fan (208) and a bell mouth (214) extending from said base (212) to define a fluid flow path. The fan cover (210) comprises a hub (218) configured to be located centrally within the hollow body of said frame and a plurality of ribs (216) extending from the base (212) to the peripheral surface of said hub (218). Further, a plurality of flaps (220, 222) are mounted on the peripheral surface of said bell mouth (214), wherein each of said flap (220, 222) is angularly displaceable to a predefined angle to direct the output air in a desired direction to prevent the generation of thermal blind spots (114) in the electronic equipment (200).

## Description

### TECHNICAL FIELD

The present invention generally relates to the field of thermal management in an electronic equipment, and more particularly to a fan cover which can optimize airflow distribution within the electronic equipment.

### BACKGROUND

Electronic equipment often relies on fans to cool various internal components, ensuring thermal management and optimal equipment performance. Typically, fans are integrated with electronic devices to regulate the temperature of different internal components. However, conventional fans used in such equipment often fail to provide uniform cooling across all components. This limitation arises because the fan blades are fixed in one direction, resulting in airflow concentrated in a single path. Consequently, certain areas within the electronic enclosure remain undercooled, creating "blind hot spots" where heat accumulates. These localized increases in temperature can degrade the performance of specific components and, over time, negatively impact the overall efficiency of the equipment.

Additionally, the rear geometry of conventional fans contributes to pressure drops, leading to airflow separation and turbulence. This phenomenon not only reduces the fan's cooling efficiency but also causes uneven air distribution, increasing the issue of blind spots. As a result, critical components situated in these areas do not receive adequate ventilation, leading to potential overheating. If not properly cooled, the excess heat can accumulate, reducing the lifespan of these internal components and posing a risk of damage or equipment failure.

Thus, there is a need for a fan optimization device such as a fan cover that can address these drawbacks and enhances the overall cooling efficiency of electronic equipment.

### SUMMARY OF THE INVENTION

This summary is provided to introduce aspects related to an improved fan assembly that can provides uniform cooling, reduce turbulence, and prevent overheating of critical components by addressing thermal blind spots in airflow.

In one aspect of the invention, a fan cover for a fan is provided which is configured to divert the air flow to provide uniform cooling, reduce turbulence and prevent overheating of critical components in an electronic equipment. The fan cover comprises a frame defined by a hollow body with a base configured to securely fit on the rear surface of the fan and a bell mouth extending from said base to define a fluid flow path. The fan cover comprises a hub configured to be located centrally within the hollow body of said frame and a plurality of ribs extending from the base to the peripheral surface of said hub. Further, a plurality of flaps are mounted on the peripheral surface of said bell mouth, wherein each of said flap is angularly displaceable to a predefined angle to direct output air in a desired direction to prevent generation of thermal blind spots in the electronic equipment.

In an aspect, the fan cover comprises a fixture configured on at least one peripheral surface of said bell mouth, said fixture being configured with a plurality of slots at different angles.

In another aspect, an extended end section of said flap is provided which is configured to protrude at least partially through said fixture, said fixture facilitating locking of said extended end section in one of said slots to divert the output air in a desired direction.

In yet another aspect, the fan cover comprises a lever configured to be mounted on said extended end section of said flap, said lever being configured to angularly displace said flap to divert the output air in a desired direction.

In an aspect, each of said flaps is pivotally mounted to facilitate automatic actuation in a desired direction based on pressure gradient across the surfaces of said flaps due to the output air.

In another aspect, said hub is defined by a bowl-shaped body having a front surface and a rear surface with a tapered diameter along operative width, wherein tapered cross-section of said hub facilitates laminar flow of air without boundary layer separation and back flow of air.

In an aspect, said fan cover is configured to be fitted on the rear surface of the fan by means of snap fit, or screw fit.

In yet another aspect, said base is provided with an operative surface that has at least a pair of projections to facilitate snap fit on rear surface of the fan.

In another aspect, each of said flaps is configured with an aerodynamic profile to reduce flow resistance during operation.

In yet another aspect, the fan cover includes sealing means, configured to be positioned between an operative surface of said base and the rear surface of the fan, said sealing means being configured to minimize air leakage and enhance the overall flow of air.

In an aspect, said fan cover is constructed of a polymeric material.

In one aspect of the invention, a method for diverting output air from a fan in an electronic equipment is provided. The method comprises the steps of: positioning a fan cover on the rear surface of the fan to establish a fluid connection with the rear surface of the fan; operating the fan to induce airflow through said fan cover; providing a plurality of displaceable flaps on said fan cover; and angularly displacing at least one of said flap of said fan cover to a predefined angle based on pre-determined airflow requirements for directing output air towards specific electronic components for avoiding thermal blind spots in the electronic equipment.

Other aspects and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG. 1** illustrates an exploded isometric view of the electronic components (PCB), a conventional fan, and the housing, which includes both the top and bottom covers;
**FIG. 2** illustrates the air flow dynamics as air exits the fan in accordance with FIG. 1;
**FIG. 3A-3B** illustrates different view of the fan cover in accordance with the present disclosure;
**FIG. 4** illustrates an exploded view demonstrating how the fan cover is fitted to an existing fan;
**FIG. 5** illustrates the air flow dynamics as air exits the fan cover in accordance with FiG. 4;
**FIG. 6A** illustrates a velocity map indicating the formation of thermal blind spot, high velocity zone and low velocity zone in the electronic equipment having the conventional fan arrangement.
**FIG. 6B** illustrates a velocity map indicating the generation of a uniform airflow distribution zones in electronic equipment using a fan cover arrangement with the fan, according to the present disclosure;
**FIG. 6C** illustrates a velocity map indicating the movement of flap at a desired angle to restrict the formation thermal blind spot and formation of air diverted zone in the electronic equipment using the fan cover arrangement with the fan, according to the present disclosure; and
**FIG. 7** illustrates method steps for redirecting air from the fan using the fan cover.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DESCRIPTION OF THE INVENTION

Illustrative examples are described with reference to the accompanying drawings. Wherever convenient, the same reference numbers are used throughout the drawings to refer to the same or like parts. While examples and features of disclosed principles are described herein, modifications, adaptations, and other implementations are possible without departing from the scope of the disclosed examples. It is intended that the following detailed description be considered as exemplary only, with the scope being indicated by the following claims.

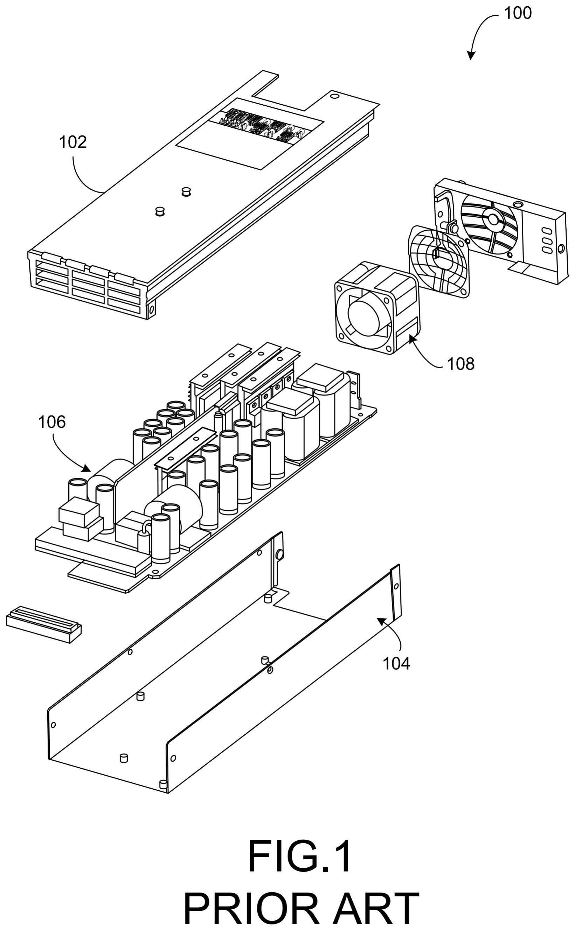

Typically, conventional fans used in electronic equipment often fail to provide consistent cooling due to their fixed flap configuration, which leads to the formation of blind spot zone where heat accumulates. **FIG. 1** illustrates an exploded isometric view of the electronic components (PCB) (106), conventional fan (108), casing with a top cover (102) and a bottom cover (104). The uneven cooling results in overheating of certain components, which negatively affects the equipment performance and can cause potential damage. Additionally, turbulence caused by pressure drops in the existing fan's configuration further reduces cooling efficiency and worsens air distribution.

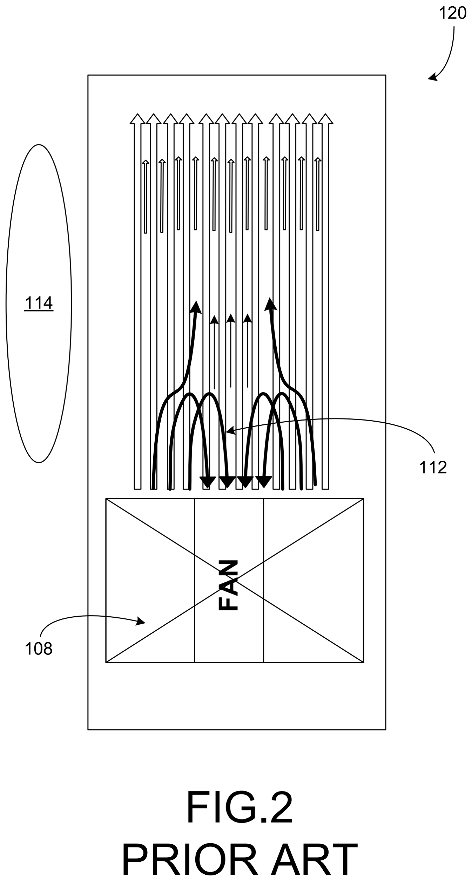

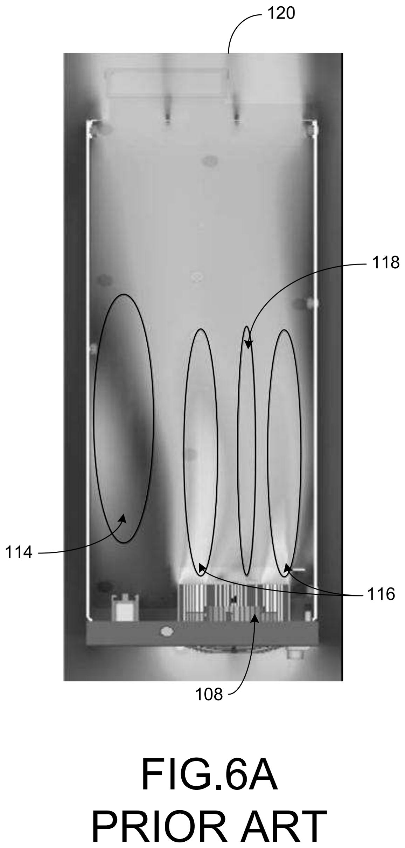

**FIG. 2** provides a detailed depiction of the air flow dynamics as the output air exits the fan (108), as referenced in FIG. 1. The illustration highlights that, at the point where the output air is discharged from the fan (108), a pressure drop occurs. This reduction in pressure leads to a reverse airflow, or backflow, which subsequently induces turbulence along the air's flow path. This turbulence (112) disrupts the smooth passage of air, affecting the overall flow characteristics and creation of blind spot zone (114), a high velocity zone (116) and a low velocity zone (118), as depicted in FIG 6A. In the context of the present disclosure, the term 'output air' herein refers to the volume and velocity of air that is discharged from the fan after it has been drawn in and propelled through its blades. It is typically measured in cubic feet per minute (CFM). The output air can also be termed as pulled-in air.

Further, the absence of mechanisms in the conventional fan (108) to guide pulled-in air to under-cooled areas may increases the risk of equipment failure. Therefore, a fan optimization system is needed to ensure uniform cooling and effective heat dissipation across all components of an equipment.

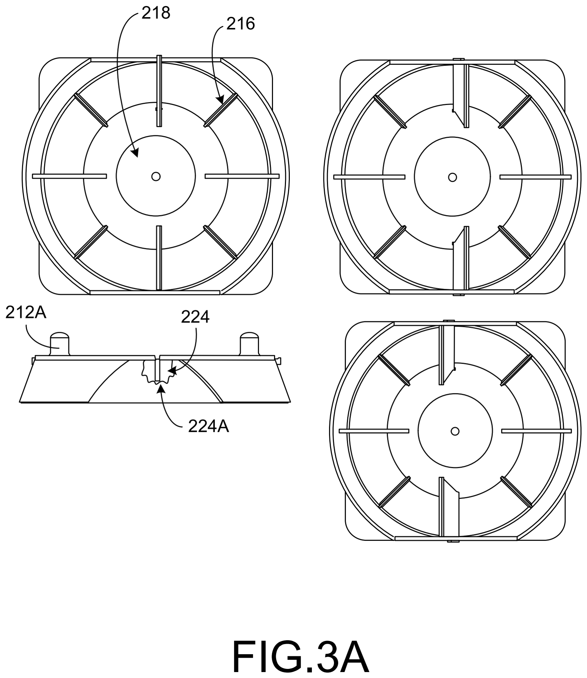

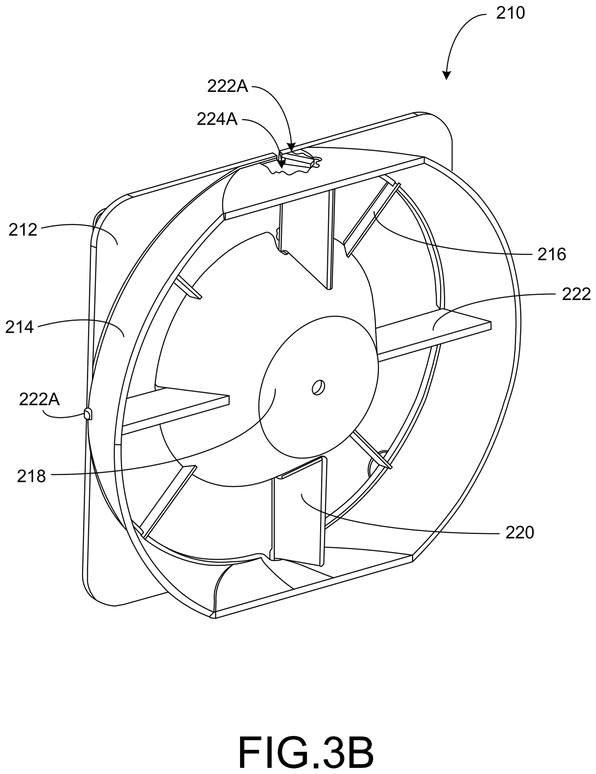

The present disclosure provides an improved fan assembly that can provides uniform cooling, reduce turbulence, and prevent overheating of critical components by addressing thermal blind spots in airflow. The disclosure also incorporates auxiliary mechanism(s) for enhanced airflow control, to ensure effective heat dissipation and improved performance of electronic equipment's. Examples, of the present disclosure, will now be described with reference to **FIG.** 3 to **FIG. 7****.**

**FIG. 3A-3B** illustrates different view of the fan cover in accordance with the present disclosure. The present disclosure provides the fan cover (210) for the fan (208). The fan (208) typically has a front and rear surface enclosed within a casing, with the rear surface facing the electronic components (200) that require cooling. The fan cover (210) can be retrofitted onto the rear surface of the fan (208) to guide or redirect the output air or the pulled-in from the fan (208) so as to optimize the airflow distribution and prevent the formation of thermal blind spots (114).

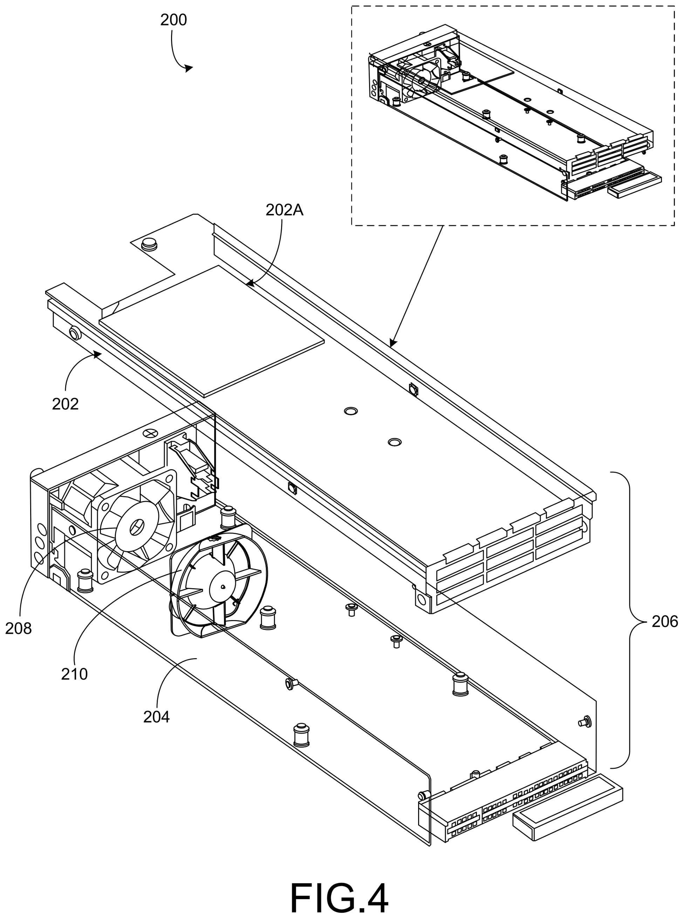

**FIG. 4** illustrates an exploded view demonstrating how the fan cover is fitted to an existing fan. In an implementation, the fan (208) with the fan cover (210) can be installed in the casing (206) of electronic equipment that contains multiple electronic components. The casing (206) may consist of a top cover (202) and a bottom cover (204), with the top cover (202) configured to include a cut-out (202A). The fan cover (210) is configured to enhance the cooling efficiency of the fan (208) by redirecting pulled-in air or the output air towards specific components within the electronic casing (206). By doing so, the components achieve optimal cooling and prevents overheating of the electronic components. In one implementation, the cut-out (202A) may be configured as label pasting area for the electronic equipment. In another implementation, the cut-out (202A) may be configured to access one or more components such as the fan cover (210) or the fan (208).

Returning to **FIG 3A-3B****,** the fan cover (210) comprises a frame, defined by a hollow body with a base (212), which can be complementary to the rear surface of the fan (208). The base (212) is configured to securely fit on the fan (208). The frame further includes a bell mouth (214), extending from the operative edge of the base (212) in an operative direction. The bell mouth (214) helps to define a fluid flow path that channels the pulled-in air or the output air of the fan (208).

In an example, the fan cover (210) may be mounted on the rear surface of the fan by means of snap-fit, or screw-fit. **FIG.** 4 illustrates how the fan cover (210) is fitted to an existing fan (108), in accordance with the present disclosure.

Further, a hub (218) is centrally located within the hollow body of the frame. The hub (218) can be configured as a bowl-shaped body with a front surface and a rear surface. In a preferred example, the hub (218) may have a tapered diameter along its width. The tapering provided over the hub (218) facilitates laminar or uniform airflow without boundary layer separation or backflow or pressure drop. The tapering effect ensures smooth and uninterrupted airflow, contributing to the improved air flow dynamics. In an example, the degree of tapering can be adjusted depending on the specific application, ranging between defined limits to optimize airflow dynamics.

In another example, the bell mouth of the fan cover may be implemented with different shapes such as conical and trapezoidal shape to achieve desired airflow distribution profiles and extract the heat from the electronic component.

In another example, the hub (218) may be securely supported in the frame by a plurality of ribs (216). Each rib (216) extending from the operative edge of the base (212) and connects to the peripheral surface of the hub (218). The rib (216) provides the necessary support to keep the hub (218) centrally positioned while maintaining hollow space for air to flow.

In yet another example, the fan cover (210) may be configured with a plurality of flaps (220, 222). Each of the flaps (220, 222) may be operatively mounted on the peripheral surface of the bell mouth (214). The flaps (220, 222) can be angularly displaceable to a predefined angle, to allow the pulled-in air or the output air to be directed towards specific electronic components. The movement or deflection of the flaps (220, 222) ensures that airflow can be adjusted in real-time based on cooling requirements, and thus preventing the formation of thermal blind spots (114) in an electronic equipment.

In an example, the flaps (220, 222) may be pivotally mounted to allow for automatic actuation based on pressure gradients caused by pulled-in air or output air.

In another example, the fan cover (210) may include a fixture (224) positioned on at least one peripheral surface of the bell mouth (214) to control the angular displacement of the flap (220, 222). The fixture (224) may feature a plurality of slots (224A) at different angles, to allow the user to lock and adjust the flap (220, 222) in a desired position at a desired angle. The extended end section (222A) of each flap (220, 222) may protrude at least partially through the fixture (224), and a lever can be mounted on the extended end section (222A) to facilitate manual adjustment. The lever enables precise angular displacement of one or more flap (220, 222) to ensure that pulled-in air is directed exactly where it is needed. The slot (224A) ensures that once the desired angle of airflow is set, the flap (220, 222) remains in place, providing consistent airflow redirection.

In yet another example, each flap (220, 222) may have an aerodynamic profile, configured to reduce airflow resistance during operation. The aerodynamic profile minimizes drag and ensures that the fan can operate at maximum efficiency without creating unnecessary turbulence. By enhancing the airflow dynamics, the fan cover (210) effectively improves the cooling performance of the fan.

In an example, the fan cover (210) may also include sealing means, positioned between the base (212) and the rear surface of the fan. The sealing means are configured to minimize air leakage, to ensure that the airflow is concentrated through the designated path created by the bell mouth (214) and flaps (220, 222). This increases the overall cooling efficiency by preventing air from escaping through unintended gaps.

In another example, to ensure compatibility with various environmental conditions and manufacturing processes, the fan cover (210) can be constructed from polymeric material or other suitable materials that offer durability and heat resistance. These materials ensure that the fan cover (210) can withstand prolonged use in high-temperature environments commonly found in electronic equipment.

In an example, the fan cover (210) may be configured to fit different fan sizes and configurations, to allow broad applicability across various electronic devices. The snap-fit or screw-fit mechanisms can be adjusted to accommodate different fan diameters, to ensure easy retrofitting without requiring significant modifications to the existing fan or electronic components. In one example, the base (212) of the fan cover (210) may include projections (212A) which acts as assembly point to fan cover so as to facilitate the snap-fit installation, to allow quick and secure attachment.

In another example, the flaps (220, 222) may be configured for automatic actuation, responding to airflow conditions in real-time. When a higher pressure builds up on one side of the flap (220, 222), the flap (220, 222) pivots to redirect the pulled-in air to under cooled areas. This automatic adjustment ensures that the fan can self-regulate airflow distribution without requiring manual intervention, thus optimizing the cooling efficiency in real-time.

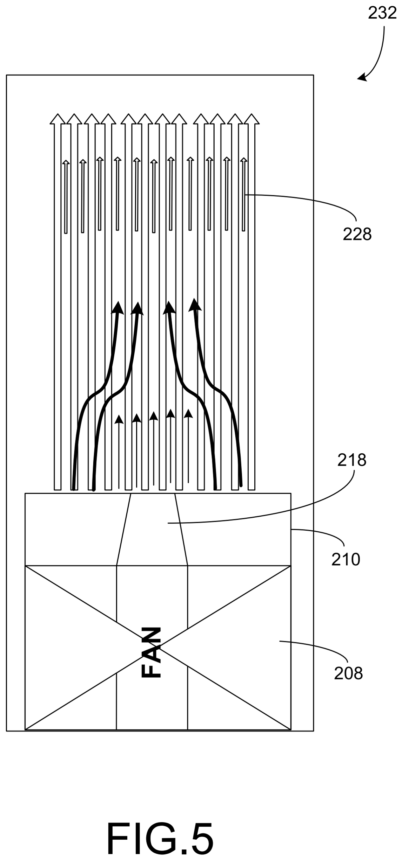

**FIG.** 5 illustrates how the fan cover (210) directs and controls pulled-in air or output air as it exits, optimizing both direction and speed. The configuration of the hub (218) at the outlet ensures smooth, laminar flow zone (228) air movement, reducing turbulence and enhancing the equipment performance by managing airflow patterns efficiently. In addition, the tapered configuration of the hub (218) can be tailored for different airflow requirements.

**FIG. 6A** illustrates a velocity map indicating the formation of thermal blind spot, high velocity zone and low velocity zone in the electronic equipment having the conventional fan arrangement. The velocity map visually represents the airflow distribution, with particular focus on the "thermal blind spot" areas where airflow is minimal or ineffective.

For the conventional fan (108) without the fan cover (210), the air flow velocity map (120) reveals significant regions where the air does not reach effectively, typically near the outer edges of the fan's divert area as shown in **FIG. 6A****.** These thermal blind spots (114) result from limitations in the airflow trajectory and distribution of output air from the fan (108). Further, due to non-availability of any guiding means, there is a pressure drop at the rear surface of the fan near to the center region, which creates the formation of high velocity zone (116) as well as low velocity zone (118) and results in turbulency in the flow as shown in FIG. 6A and FIG. 2.

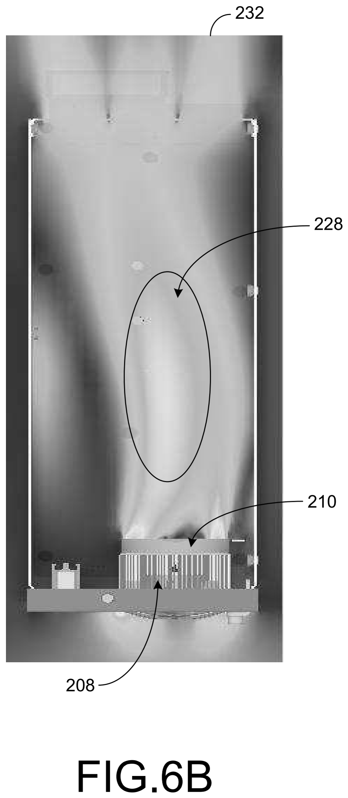

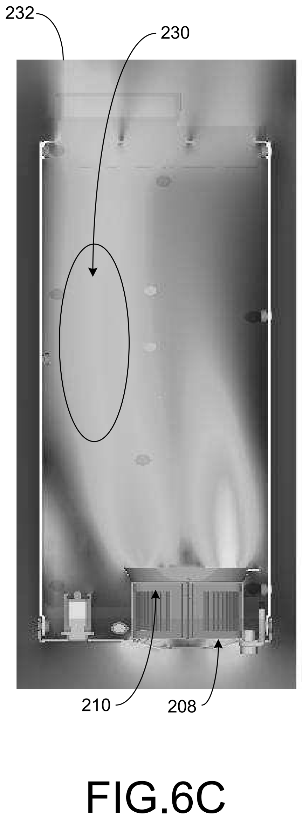

**FIG. 6B** illustrates a velocity map indicating the generation of a uniform airflow distribution zones in electronic equipment using a fan cover arrangement with the fan, according to the present disclosure, and FIG. 6C illustrates a velocity map indicating the movement of flap at a desired angle to restrict the formation thermal blind spot and formation of air diverted zone in the electronic equipment using the fan cover arrangement with the fan, according to the present disclosure.

The velocity map (232) for the fan with the fan cover (210) demonstrates a noticeable reduction in these thermal blind spots (114). The fan cover (210), configured to divert and optimize the airflow more efficiently, ensures more uniform airflow zone (228). The areas that were previously under-ventilated or entirely missed by the airflow in the fan without the fan cover (210) show substantial improvement with the fan cover (210) in place, reflecting an optimized air distribution pattern indicated as air flow diverted zone (230) as shown in **FIG. 6B** **and** **6C****.**

This comparative analysis illustrates the technical advantage of using the fan cover (210) to enhance the performance of the fan by eliminating blind spots (114) and achieving a more effective airflow.

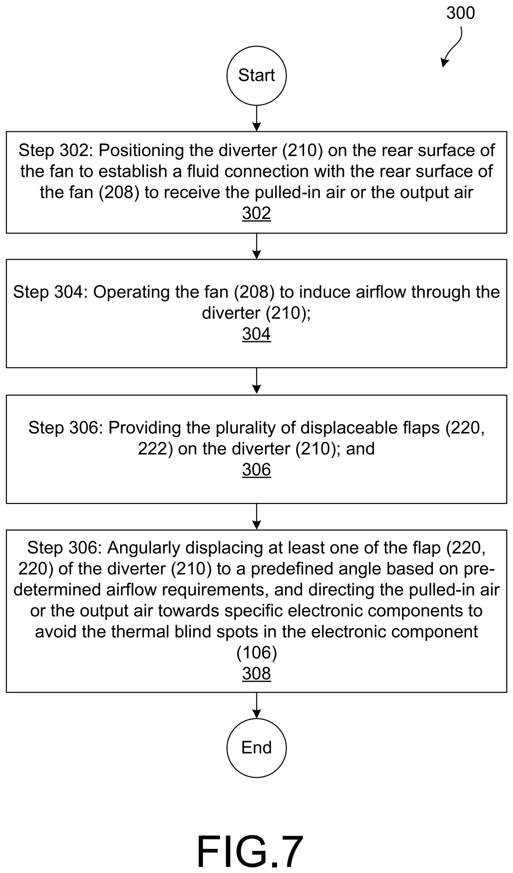

**FIG. 7** illustrates method steps for redirecting air from the fan using the fan cover, in accordance with the present disclosure. The method (300) may comprise the following steps:
In Step 302: positioning the fan cover (210) on the rear surface of the fan to establish a fluid connection with the rear surface of the fan (208) to receive the pulled-in air or the output air;
In Step 304: operating the fan (208) to induce airflow through the fan cover 5 (210);
In Step 306: providing the plurality of displaceable flaps (220, 222) on the fan cover (210); and
In Step 306: angularly displacing at least one of the flap (220, 222) of the fan cover (210) to a predefined angle based on pre-determined airflow 10 requirements and directing the pulled-in air or the output air towards specific electronic components to avoid the thermal blind spots in the electronic component (106).

The method is characterized whereby adjusting angle of said flaps (220, 222) in real-time for optimizing the airflow dynamics to maintain a consistent and effective cooling of at 15 least one electronic component of the equipment.

The above-described features of the fan cover (210) such as the angularly adjustable flaps (220, 222) ensure uniform cooling of component(s) by directing the pulled-in air or the output air of the fan towards under-cooled areas, and thus can eliminate the thermal blind spots (114). The optimized hub (218) configuration with tapering ensures reduced turbulence, minimizing flow separation and improving airflow efficiency. The flap (220, 222) adjustment mechanism (both manual and/or automatic) allows real-time airflow control, to prevent the overheating of critical components and can ensure consistent equipment performance. By using adaptable fitting methods and durable materials, the fan cover (210) can be easily integrated into existing fan, and thus enhancing equipment reliability and longevity.

In an exemplary example, the airflow rate is measured for both with a conventional fan without the fan cover and with the fan fitted with the fan cover (210) attachment. A series of sensors are mounted on the central hub of the fan and along the sides to monitor the airflow dynamics. For the conventional fan without the fan cover, the velocity at the center of the fan is recorded at 4.8 m/s, with a feet per minute (FPM) value of 944.9 and a cubic feet per minute (CFM) value of 31.9. At the sides of the fan, the velocity is observed at 12.7 m/s, with an FPM of 2500 and a CFM of 84.5. 5

In contrast, when the fan cover (210) attachment is used with the fan, the velocity at the center of the hub increases to 8.9 m/s, with an FPM of 1752.0 and a CFM of 59.2. At the sides, the velocity rises to 15 m/s, with an FPM of 2952.8 and a CFM of 99.8. These results or observations clearly demonstrate that the attachment of the fan cover (210) significantly enhances airflow velocity, as well as FPM and CFM, nearly doubling their 10 values. As a result, the fan cover (210) enables more uniform airflow distribution and prevents the formation of thermal blind spots within the casing of the electronic components.

Therefore, the present disclosure not only improves the efficiency of cooling of the electronic components but also ensures better airflow management, which prolongs the lifespan of electronic components and reduces the risk of equipment or component failure.

The present disclosure described hereinabove has several technical advantages including, but not limited to, the fan cover and the method of diverting output air using fan cover, that (a) can ensures uniform airflow distribution across all components of the electronic equipment to eliminate thermal blind spots and thus preventing the localized overheating of the internal components; (b) can redirect pulled-in air or the output air to ensure that all components receive adequate ventilation regardless of their position within the electronic enclosure; (c) can minimize pressure drops and flow separation by improving the rear surface geometry of the conventional fan, thereby reducing turbulence and enhancing the cooling efficiency; (d) can mitigate uneven air distribution to ensure that critical components located in traditionally under-cooled areas receive consistent cooling; (e) can divert or guide the pulled-in air or the output of the fan toward areas prone to heat build-up, thereby improving overall equipment cooling; (f) can prolong the lifespan of the electronic components and maintains equipment performance by preventing overheating of the electronic equipment; (g) can maintains optimal cooling across all internal components to reduce the risk of equipment failure, and increase the overall operational efficiency of the electronic equipment; and (h) can be easily integrated or retrofitted in an existing fan without significant modifications to ensure compatibility with various equipment configurations.

The methods, systems, devices, graphs, and/or tables discussed herein are examples. Various examples may omit, substitute, or add various procedures or components as appropriate. For instance, in alternative examples, the methods may be performed in an order different from that described, and/or various stages may be added, omitted, and/or combined. Also, features described with respect to certain examples may be combined in various other examples. Different aspects and elements of the examples may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

Further examples are set out in the clauses below:
1. A fan cover (210) for a fan (208), said fan cover (210) being configured to divert output air of the fan (208) in an electronic equipment (200) to prevent generation of thermal blind spots (114), said fan cover (210) comprising:
   a frame defined by a hollow body with a base (212), said base (212) configured to securely fit on rear surface of the fan (208);
   a bell mouth (214) extending from an operative edge of said base (212) in an operative direction to define a fluid flow path, said bell mouth (214) channelling the output air of the fan (208) towards at least one electronic component of the equipment (200);
   a hub (218) configured to be located centrally within the hollow body of said frame;
   a plurality of ribs (216), each of said rib (216) extending from the operative edge of said base (212) to peripheral surface of said hub (218), said ribs (216) configured to rigidly secure the hub (218) within hollow space; and
   a plurality of flaps (220, 222) operatively mounted on the peripheral surface of said bell mouth (214),
   wherein each of said flap (220, 222) is configured to be angularly displaceable to a predefined angle to direct the output air in a desired direction to prevent the generation of thermal blind spots (114) in the electronic equipment (200).
2. The fan cover (210) of clause 1, comprising:
   a fixture (224), configured on at least one peripheral surface of said bell mouth (214), said fixture (224) being configured with a plurality of slots (224A) at different angles.
3. The fan cover (210) of clause 2, wherein an extended end section (222A) of said flap (220, 222) is configured to protrude at least partially through said fixture (224), said fixture (224) facilitating locking of said extended end section (222A) in one of said slots (224A) to divert the output air in a desired direction.
4. The fan cover (210) of clause 3, comprising: a lever, configured to be mounted on said extended end section (222A) of said flap (220, 222), said lever being configured to angularly displace said flap (220, 222) to divert the output air in a desired direction.
5. The fan cover (210) of any one of the preceding clauses, wherein each of said flaps (220, 222) is pivotally mounted to facilitate automatic actuation in a desired direction based on pressure gradient across the surfaces of said flaps (220, 222) due to the output air.
6. The fan cover (210) of any one of the preceding clauses, wherein said hub (218) is defined by a bowl-shaped body having a front surface and a rear surface with a tapered cross-section along an operative width.
7. The fan cover (210) of clause 6, wherein the tapered cross-section of said hub (218) facilitates laminar flow of air without boundary layer separation and back flow of air.
8. The fan cover (210) of any one of the preceding clauses, wherein said fan cover (210) is configured to be fitted on the rear surface of the fan (208) by means of snap fit, or screw fit.
9. The fan cover (210) of any one of the preceding clauses, wherein an operative surface of said base (212) has at least a pair of projections (212A) to facilitate snap fit on the rear surface of the fan (208).
10. The fan cover (210) of any one of the preceding clauses, wherein each of said flaps (220, 222) is configured with an aerodynamic profile to reduce flow resistance during operation.
11. The fan cover (210) of any one of the preceding clauses, which includes sealing means, configured to be positioned between an operative surface of said base (212) and the rear surface of the fan (208), said sealing means being configured to minimize air leakage and enhance the overall flow of air.
12. The fan cover (210) of any one of the preceding clauses, said fan cover (210) is constructed of a polymeric material.
13. A method for diverting output air from a fan (208) in an electronic equipment (200), comprising:
   positioning a fan cover (210) on the rear surface of the fan (208) to establish a fluid connection with the rear surface of the fan (208);
   operating the fan (208) to induce airflow through said fan cover (210);
   providing a plurality of displaceable flaps (220, 222) on said fan cover (210); and
   angularly displacing at least one of said flap (220, 222) of said fan cover (210) to a predefined angle based on pre-determined airflow requirements for directing output air towards specific electronic components for avoiding thermal blind spots (114) in the electronic equipment (200).

While illustrative and presently preferred examples of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

## Claims

1. A fan cover (210) for a fan (208), said fan cover (210) being configured to divert output air of the fan (208) in an electronic equipment (200) to prevent generation of thermal blind spots (114), said fan cover (210) comprising:
a frame defined by a hollow body with a base (212), said base (212) configured to securely fit on rear surface of the fan (208);
a bell mouth (214) extending from an operative edge of said base (212) in an operative direction to define a fluid flow path, said bell mouth (214) channelling the output air of the fan (208) towards at least one electronic component of the equipment (200);
a hub (218) configured to be located centrally within the hollow body of said frame;
a plurality of ribs (216), each of said rib (216) extending from the operative edge of said base (212) to peripheral surface of said hub (218), said ribs (216) configured to rigidly secure the hub (218) within hollow space; and
a plurality of flaps (220, 222) operatively mounted on the peripheral surface of said bell mouth (214),
wherein each of said flap (220, 222) is configured to be angularly displaceable to a predefined angle to direct the output air in a desired direction to prevent the generation of thermal blind spots (114) in the electronic equipment (200).

2. The fan cover (210) as claimed in claim 1, comprising:
a fixture (224), configured on at least one peripheral surface of said bell mouth (214), said fixture (224) being configured with a plurality of slots (224A) at different angles.

3. The fan cover (210) as claimed in claim 2, wherein an extended end section (222A) of said flap (220, 222) is configured to protrude at least partially through said fixture (224), said fixture (224) facilitating locking of said extended end section (222A) in one of said slots (224A) to divert the output air in a desired direction.

4. The fan cover (210) as claimed in claim 3, comprising:
a lever, configured to be mounted on said extended end section (222A) of said flap (220, 222), said lever being configured to angularly displace said flap (220, 222) to divert the output air in a desired direction.

5. The fan cover (210) as claimed in claim 1, wherein each of said flaps (220, 222) is pivotally mounted to facilitate automatic actuation in a desired direction based on pressure gradient across the surfaces of said flaps (220, 222) due to the output air.

6. The fan cover (210) as claimed in any one of the preceding claims, wherein said hub (218) is defined by a bowl-shaped body having a front surface and a rear surface with a tapered cross-section along an operative width.

7. The fan cover (210) as claimed in claim 6, wherein the tapered cross-section of said hub (218) facilitates laminar flow of air without boundary layer separation and back flow of air.

8. The fan cover (210) as claimed in any one of the preceding claims, wherein said fan cover (210) is configured to be fitted on the rear surface of the fan (208) by means of snap fit, or screw fit.

9. The fan cover (210) as claimed in any one of the preceding claims, wherein an operative surface of said base (212) has at least a pair of projections (212A) to facilitate snap fit on the rear surface of the fan (208).

10. The fan cover (210) as claimed in any one of the preceding claims, wherein each of said flaps (220, 222) is configured with an aerodynamic profile to reduce flow resistance during operation.

11. The fan cover (210) as claimed in any one of the preceding claims, which includes sealing means, configured to be positioned between an operative surface of said base (212) and the rear surface of the fan (208), said sealing means being configured to minimize air leakage and enhance the overall flow of air.

12. The fan cover (210) as claimed in any one of the preceding claims, said fan cover (210) is constructed of a polymeric material.

13. A method for diverting output air from a fan (208) in an electronic equipment (200), comprising:
positioning a fan cover (210) on the rear surface of the fan (208) to establish a fluid connection with the rear surface of the fan (208);
operating the fan (208) to induce airflow through said fan cover (210);
providing a plurality of displaceable flaps (220, 222) on said fan cover (210); and
angularly displacing at least one of said flap (220, 222) of said fan cover (210) to a predefined angle based on pre-determined airflow requirements for directing output air towards specific electronic components for avoiding thermal blind spots (114) in the electronic equipment (200).
